Europäisches Patentamt

European Patent Office

Office européen des brevets

(11) Veröffentlichungsnummer: **0 191 470**
**A1**

## (12) EUROPÄISCHE PATENTANMELDUNG

(21) Anmeldenummer: 86101762.2

(22) Anmeldetag: 12.02.86

(51) Int. Cl.⁴: **H03M 1/36**

(30) Priorität: 12.02.85 DE 3504746

(43) Veröffentlichungstag der Anmeldung:
**20.08.86 Patentblatt 86/34**

(84) Benannte Vertragsstaaten:
**AT DE FR GB IT NL**

(71) Anmelder: **Siemens Aktiengesellschaft Berlin und München**
**Wittelsbacherplatz 2**
**D-8000 München 2(DE)**

(72) Erfinder: **Zojer, Bernhard, Dipl.-Ing.**
**Bahnhofplatz 9**
**A-9500 Villach(DE)**

(54) **Schneller Analog-Digital-Wandler.**

(57) Zur Verbesserung der dynamischen Linearität eines Analog-Digital-Wandlers nach dem Parallelverfahren mit taktgesteuerten Komparatoren werden die Bahnwiderstände (11 bis 18, 21 bis 28, 31 bis 34) der dem Taktsignal (TS) und dem Analogsignal (AS) zugeordneten Leitungen so gewählt, daß für jeden Abtastvorgang die Differenz der Signallaufzeiten zu demjenigen Komparator konstant ist, dessen Referenzspannung der Analogspannung im Abtastmoment am nächsten liegt.

Rank Xerox

## Schneller Analog-Digital-Wandler

Die vorliegende Erfindung betrifft einen Analog-Digital-Wandler nach dem Oberbegriff des Patentanspruchs 1.

Für schnelle Analog-Digital-Wandler, die eine analoge Spannung in eine proportionale binäre Zahl umwandeln, wird meistens das Parallelverfahren herangezogen. Dabei wird die analoge Eingangsspannung gleichzeitig mit äquidistanten Referenzspannungen verglichen und die nächstliegende festgestellt. Die Referenzspannungen werden mit Hilfe eines Spannungsteilers erzeugt und für jede mögliche binäre Zahl benötigt man einen Komparator, beispielsweise benötigt ein 6-Bit-Analog-Digital-Wandler 64 Komparatoren.

Bei nach dem Parallelverfahren arbeitenden Analog-Digital-Wandlern ergeben sich in der Regel Linearitätsfehler. Die statische Linearität ist dabei durch die Eingangsströme der Komparatoren eingeschränkt, die auch mit dem Referenzspannungsteiler verbunden sind. Dieses Problem ist Gegenstand der Patentanmeldung VPA 84 P 5301, die eine Möglichkeit angibt, die Widerstände des Referenzspannungsteilers so zu dimensionieren, daß die Referenzspannung nur an dem Komparator exakt anliegt, der der Analogspannung im Abtastmoment am nächsten liegt bzw. auf das Analogsignal reagiert. Alle anderen Referenzspannungen können vom Idealwert abweichen, ohne daß dies einen Einfluß auf das digitale Ausgangssignal hat.

Die dynamische Linearität schneller Analog-Digital-Wandler wird durch die Phasenbeziehungen des Takt- und Analogsignals beeinflußt. Allgemein lassen sich größere Phasendifferenzen durch kurze Leitungsführungen verbessern.

Der Erfindung liegt die Aufgabe zugrunde, die dynamische Linearität eines Analog-Digital-Wandlers zu verbessern.

Diese Aufgabe wird bei einem Analog-Digital-Wandler der eingangs genannten Art erfindungsgemäß durch die Merkmale des kennzeichnenden Teils des Patentanspruchs 1 gelöst.

Weitere Ausgestaltungen des Erfindungsgedankens sind in Unteransprüchen gekennzeichnet.

Die Erfindung wird im folgenden anhand eines in der einzigen Figur dargestellten Ausführungsbeispiels näher erläutert, die ein Blockschaltbild eines erfindungsgemäßen Analog-Digital-Wandlers zeigt.

Die Takt- und Analogsignale pflanzen sich entlang RC-Leitungen fort, und die Signallaufzeiten sind im wesentlichen durch die Bahnwiderstände $R_i$ der Leitungen und die Komparator-Eingangskapazitäten $C_i$ bestimmt sind. Allerdings sind die analogseitigen Eingangsimpedanzen der Komparatoren und damit die Laufzeitunterschiede zwischen Analog- und Taktsignal von der Analogspannung abhängig. Allein eine Verkürzung der Leitungslängen verkürzt zwar die absoluten Laufzeiten, eliminiert jedoch nicht die Laufzeitdifferenzen.

Im Sinne der Aufgabe der Erfindung ist es eine hinreichende Bedingung, gleiche Laufzeiten zwischen Takt- und Analogsignal nur zu demjenigen Komparator zu gewährleisten, dessen Referenzspannung im Abtastmoment der Analogspannung am nächsten liegt bzw. auf das Analogsignal reagiert.

Erfindungsgemäß kann daher die Spannungsabhängigkeit der Eingangsimpedanz jedes Komparators durch eine Ortsabhängigkeit ersetzt werden, d.h. jedem Komparator wird eine relevante Kapazität und damit relevante Laufzeitdifferenz zugeordnet. Anschließend werden die Leitungsführungen im Sinne einer für jeden Komparator geltenden gleichen Laufzeitdifferenz optimiert. Als Parameter können dazu die Leiterbahnbreite und -dicke sowie die Anordnung parallel geschalteter Leiterbahnen in verschiedenen Ebenen, z.B. einer integrierten Schaltung dienen.

Es ist zweckmäßig, die Takt- und Analogsignale bezogen auf die Komparatoren zentral einzuspeisen. Aus technologischen Gründen ist oft eine kreisförmige Anordnung der Komparatoren um einen zentralen Einspeisepunkt nicht möglich. Erfindungsgemäß ist es speziell zweckmäßig, die Komparatoren blockweise zusammenzufassen. Für den Anfang und das Ende jedes Blockes bzw. für jeden Block an sich ist es möglich, eine relevante Kapazität zu bestimmen. In Weiterbildung des Erfindungsgedankens werden dann die Bahnwiderstände zum Anfang bzw. Ende jeden Blockes oder zu jedem Block so gewählt, daß sich jeweils gleiche Laufzeitdifferenzen ergeben.

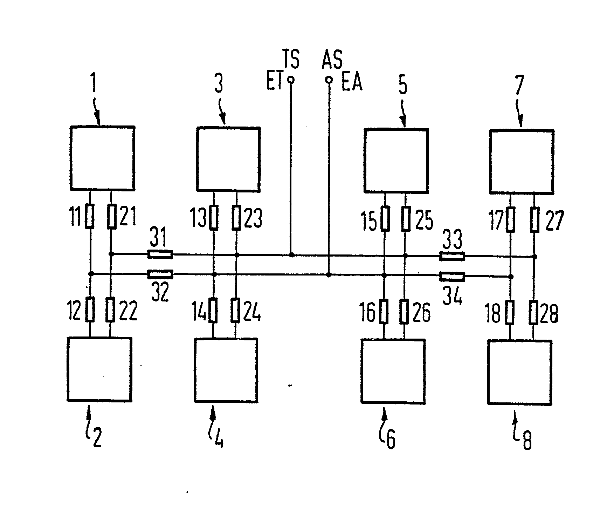

Fig. 1 stellt ein Blockschaltbild eines Ausführungsbeispiels eines erfindungsgemäßen Analog-Digital-Wandlers dar. Die Blöcke 1 bis 8 symbolisieren beispielsweise acht Komparatoren eines 3-Bit-Analog-Digital-Wandlers oder 8 Komparatorenblöcke mit je 32 Komparatoren eines 8-Bit-Analog-Digital-Wandlers. Die Blöcke 1 bis 8 sind vom Taktsignal TS gesteuert, gleichzeitig liegt an ihnen das Analogsignal AS an. Jedem Block 1 bis 8 sind relevante Kapazitäten $C_{11}$ - $C_{18}$ für das Analogsignal, $C_{21}$ - $C_{28}$ für das Taktsignal zugeordnet.

Die von den Einspeisepunkten ET des Taktsignals TS und EA des Analogsignals AS zu den jeweiligen Blöcken 1 bis 8 liegenden Widerstände 11 bis 18 sowie 32 und 34 für das Analogsignal AS bzw. die Widerstände 21 bis 28 sowie 31 und 33, die die Bahnwiderstände symbolisieren, werden für den jeweiligen Block 1 bis 8 so gewählt, daß die relevanten Laufzeitdifferenzen für die Blöcke 1 bis 8 jeweils gleich sind.

### Ansprüche

1. Analog-Digital-Wandler nach dem Parallelverfahren mit taktgesteuerten Komparatoren und eingespeisten Takt- und Analogsignalen, **gekennzeichnet** durch gleiche Laufzeiten der Takt (TS)- und Analogsignale (AS) mindestens zu dem taktgesteuerten Komparator, dessen Referenzspannung im Abtastmoment der Analogspannung am nächsten liegt.

2. Analog-Digital-Wandler nach Anspruch 1, **gekennzeichnet** durch zentrale Takt (ET)- und Analogsignaleinspeisung - (EA) bezogen auf die taktgesteuerten Komparatoren (1 bis 8).

3. Analog-Digital-Wandler nach Anspruch 1 oder 2, **dadurch gekennzeichnet,** daß die Bahnwiderstände (11 bis 18, 21 bis 28, 31 bis 34) der Takt- und Analogsignalleitungen an die taktgesteuerten Komparatoren (1 bis 8) angepaßt sind.

4. Analog-Digital-Wandler nach einem der Ansprüche 1 bis 3, **gekennzeichnet** durch zu Blöcken zusammengefaßte taktgesteuerte Komparatoren (1 bis 8) und gleiche Laufzeiten für Takt (TS)- und Analogsignale (AS) mindestens zu dem Komparatorblock (1 bis 8), dessen Referenzspannung im Abtastmoment der Analogspannung am nächsten liegt.

5. Analog-Digital-Wandler nach einem der Ansprüche 1 bis 4, **gekennzeichnet,** durch zentrale Takt (ET)- und Analogsignaleinspeisung (EA) bezogen auf die taktgesteuerten Komparatorenblöcke (1 bis 8).

6. Analog-Digital-Wandler nach einem der Ansprüche 1 bis 5, **dadurch gekennzeichnet,** daß die Bahnwiderstände - (11 bis 18, 21 bis 28, 31 bis 34) der Takt- und Analogsignalleitungen an die taktgesteuerten Komparatorenblöcke (1 bis 8) angepaßt sind.

TS    AS

ET o    o EA

1    3    5    7

11 21    13 23    15 25    17 27

31    33

32    34

12 22    14 24    16 26    18 28

2    4    6    8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | ELECTRONIC DESIGN, Band 32, Nr. 9, 3. Mai 1984, Seiten 381-388,Denville, New York, US; J. NEAL et al.: "Track-and-holds take flash converters to their limits" <br> * Seite 381 - Seite 384, linke Spalte, Zeile 1; Abbildung 1 * | 1 | H 03 M 1/36 |
| A | MICROELECTRONICS AND RELIABILITY, Band 21, Nr. 6, 1981, Seiten 837-849, Pergamon Press Ltd., Oxford, GB; M. LONSBOROUGH: "A 6-bit monolithic video flash converter" <br> * Seite 837, letzter Absatz; Abbildung 1; Seite 840, Abbildung 4 * | 1 | |
| A | DE-A-2 946 934 (MARQUARDT) | | |

RECHERCHIERTE SACHGEBIETE (Int. Cl.4)

H 03 M 1/36

Der vorliegende Recherchenbericht wurde für alle Patentansprüche erstellt.

| Recherchenort <br> DEN HAAG | Abschlußdatum der Recherche <br> 14-05-1986 | Prüfer <br> GUIVOL Y. |
|---|---|---|

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82